Europäisches Patentamt

European Patent Office

Office européen des brevets

(19)

(11) **EP 0 577 652 B1**

(12) **EUROPÄISCHE PATENTSCHRIFT**

(45) Veröffentlichungstag und Bekanntmachung des Hinweises auf die Patenterteilung:
**06.11.1996  Patentblatt 1996/45**

(21) Anmeldenummer: **92906916.9**

(22) Anmeldetag: **26.03.1992**

(51) Int Cl.⁶: **H03H 9/02**

(86) Internationale Anmeldenummer:
**PCT/EP92/00679**

(87) Internationale Veröffentlichungsnummer:
**WO 92/17937 (15.10.1992 Gazette 1992/26)**

(54) **OBERFLÄCHENWELLENANORDNUNG MIT EINER STRUKTUR ZUR VERMEIDUNG STÖRENDER AKUSTISCHER WELLENANTEILE**

SURFACE-WAVE DEVICE WITH A FEATURE DESIGNED TO AVOID ACOUSTIC-WAVE INTERFERENCE

DISPOSITIF A ONDES DE SURFACE AYANT UNE STRUCTURE QUI PERMET D'ELIMINER DES COMPOSANTES PERTURBATRICES DES ONDES ACOUSTIQUES

(84) Benannte Vertragsstaaten:
**CH DE FR GB LI**

(30) Priorität: **28.03.1991  DE 4110401**

(43) Veröffentlichungstag der Anmeldung:
**12.01.1994  Patentblatt 1994/02**

(73) Patentinhaber: **SIEMENS AKTIENGESELLSCHAFT 80333 München (DE)**

(72) Erfinder:
• **SCHROPP, Isidor**
 **D-8071 Ernsgaden (DE)**

• **ANEMOGIANNIS, Kimon**
 **D-8000 München 60 (DE)**
• **VISINTINI, Giuliano**
 **D-8025 Unterhaching (DE)**

(56) Entgegenhaltungen:
**EP-A- 0 057 598**

• **PATENT ABSTRACTS OF JAPAN vol. 7, no. 062 (E-164) 15. März 1983 & JP-A-57 208 719**
• **PATENT ABSTRACTS OF JAPAN vol. 10, no. 125 (E-402)(2182) 10. Mai 1986 & JP-A-60 256 214**

**Beschreibung**

Die vorliegende Erfindung bezieht sich auf eine Oberflächenwellenanordnung, die auf der Oberfläche eines piezoelektrischen Substrats Interdigitalwandler und gegebenenfalls weitere Strukturen hat. Die Interdigitalwandler dienen dazu, elektrische Signale in akustische Oberflächenwellen und umgekehrt umzusetzen. Weitere Strukturen können Resonatorstrukturen, Reflektorstrukturen oder auch Konversionsstrukturen sein, wie sie aus der WO 89/02675 bekannt sind.

Auf oder in der Oberfläche bzw. in oberflächennahem Bereich des jeweiligen Substratkörpers verlaufen mit dem allgemeinen Begriff "Oberflächenwellen" bezeichnete akustische Wellen, die Rayleigh-Wellen, Bleustein-Wellen, Surface Skimming Bulk-Wellen und dergleichen sind. Abgesehen von Apertur- und Beugungseffekten verlaufen solche akustischen Wellen in einer als Hauptwellen Ausbreitungsrichtung bezeichneten Richtung, mit den Wandlern entsprechend gradlinigen zu dieser Richtung querstehenden, Wellenfronten, wobei auch die Gegenrichtung mit eingeschlossen ist. Von einem Interdigitalwandler werden nämlich solche akustischen Wellen in Richtung und Gegenrichtung als Hauptwellenausbreitungsrichtung ausgesandt, sofern dieser Wandler nicht speziell als Unidirektionalwandler ausgebildet ist.

Der Substratkörper einer solchen Oberflächenwellenanordnung ist ein im Regelfall längliches Plättchen, das rechteckig ist oder dessen Schmalseiten schräg zu den Längskanten des Plättchens ist. Mit einer solchen Schrägrichtung läßt sich erreichen, daß auf diese Endkante des Plättchens auftreffende, in der Hauptwellenausbreitungsrichtung laufende akustische Wellen an dieser Kante nicht in die Hauptwellenausbreitungsrichtung zurückreflektiert werden. Generell ist es aber üblich, stattdessen oder zusätzlich einen sogenannten Sumpf auf bzw. an dem Substratplättchen im Bereich einer betreffenden Endkante des Substratplättchens anzubringen. Das Material eines solchen Sumpfes hat die Eigenschaft, in den Bereich dieses Sumpfes gelangende Wellen der Oberflächenwellenanordnung zu absorbieren, das heißt nicht mehr in die auf der Substratoberfläche aufgebrachten Strukturen zurückgelangen zu lassen.

Aus den Druckschriften GB-A-2048010, EP-0057 598 und DE-B-2738192 ist es bekannt, der äußeren Umrandung eines auf der Substratoberfläche aufgebrachten Fleckes aus absorbierendem Material eine bestimmte Form zu geben, z.B. als großflächiges Dreieck mit Zig-Zog-Kante oder anderweitig unregelmäßiger Form. Eine andere Form (DE-B-2738192, Fig. 4, 5 u. 6) ist diejenige mit einer Sägezahnform. Soweit eine solche sägezahnförmige Kante der Welle entgegengerichtet ist, sind damit Totalreflexionseffekte ausgeschlossen (auf die es bei der noch zu beschreibenden Erfindung ankommt). Eine Sägezahnform entlang der dazu rückwärtigen Kante ist, selbst wenn diese die Winkelbedingungen der Totalreflexion erfüllen würde, praktisch ohne Belang, da an diesem Ort die Welle ohnehin schon im wesentlichen auf nahe Null gedämpft ist.

Solche Materialien für aktustische Absorbtion sind mit Lösungsmittel versetzte Kunststoffe und dergleichen, deren Abdampfungen die elektrischen Eigenschaften einer Oberflächenwellenanordnung sogar über lange Zeit hinweg fortlaufend verändern. Für hochwertige Anordnungen ist solches Material im geschlossenen Gehäuse der Anordnung sehr nachteilig.

So sind Vorschläge gemacht worden, nämlich als Falle für akustische Wellen in der Anordnung, im Winkel angeordnete, Einschnitte in dem Material der Rückseite des Substratplättchens (DE-B-2450831) zu erzeugen oder winklige Kerben in die Kanten des Substrats einzuschneiden (DE-A-2131614). Für eine Oberflächenwellenanordnung mit einer piezoelektrischen Schicht auf einem nicht-piezoelektrischen Substrat ist in der JP-A-60-256214 vorgesehen, die Kante dieser piezoelektrischen Schicht in Zig-Zag verlaufen zu lassen. Solche Maßnahmen sind, abgesehen von ihrer geringen Wirksamkeit, relativ kostspielig.

Einen Weg, der auch ohne absorbierenden Kunststoff und ohne Einschnitte in das Substratmaterial sehr effektiv ist, ist in der eingangs bereits genannten Druckschrift WO 89/02675 angegeben. Es ist dort eine Konversionsstruktur beschrieben, die, eine Metallisierung der Substratoberfläche ist und die aus solchen Streifenanordnungen besteht, wie sie auch für Resonator- bzw. Reflektoranordnungen verwendet werden. Da diese Konversionsstrukturen aber nicht Bestandteil der eigentlichen Oberflächenwellenanordnung sind, befinden sich diese Konversionsstrukturen auch außerhalb des Bereichs der Strukturen, die die Funktion der Oberflächenwellenanordnung als Resonator oder als Filter bestimmen. Eine solche Konversionsstruktur hat eine in der Druckschrift näher beschriebene Bemessung, die dazu dient und bewirkt, daß eine in der Oberflächen des Substratkörpers laufende akustische Oberflächenwelle in eine Volumenwelle umgewandelt wird, das heißt aus der Oberfläche des Substratkörpers in dessen Volumen abgelenkt wird, und dort in dem Massekörper der Substratscheibe verschwindet.

Der Grund für die bekannte Verwendung eines Sumpfes, abgeschrägte Enden des Substrates, von Einschnitten das Substrat oder einer Konversionsstruktur ist es zu vermeiden, daß ansonsten an den Kanten des Substratkörpers unerwünschterweise reflektierte Oberflächenwellen auftreten und bei ihrem Zurücklaufen in die eigentlichen Strukturen der Oberflächenwellenanordnung, zum Beispiel eines Filters, Störungen verursachen, insbesondere im Sperrbereich eines solchen Filters unerwünschte Signale auftreten lassen. Abgeschrägte Enden des Substratplättchens lassen sich nämlich insbesondere dann nicht als wie hier beabsichtigte Maßnahme verwenden, wenn die Oberflächenwellenanordnung eine mehrspurige Anordnung ist, bei der Oberflächenwellen in einer ersten Spur mit einer Hauptwellenausbereitungsrichtung und in einer zweiten Spur mit der gleichen Hauptwellenausbreitungsrichtung, jedoch parallel versetzt, und in gegebenenfalls weiteren parallelen Spuren verlaufen. Die schräg gerichtete Substratkante würde dann gerade negativ wirken, nämlich auf diese Kante auftreffende Oberflächenwellenanteile der einen Spur in die andere Spur hineinreflektiert werden. Es sei darauf hingewiesen, daß solche mehrspurigen Anordnungen auch gewolltermaßen schräg laufende Spuren haben können, die zum Beispiel eine Maßnahme der elektroakustischen Kopplung solcher Parallelspuren ist. Filter solcher Art sind bekannt aus WO 90/03690, WO 90/03692, WO 90/03691 und JP-A-57-208719. In Fig. 2 der letztgenannten Druckschrift dient eine dreieckige Reflektor-Belegung dazu, den dieser Belegung benachbarten Wandler zu einem frequenzunabhängig unidirektionalen Wandler zu machen. Man hat dabei auch an Totalreflexion gedacht, wozu aber erst ein Material gefunden werden müßte, dessen Totalreflexionswinkel größer als 45° ist. Die zweimalige 45°-Reflexion der Welle ist nämlich Voraussetzung für das Erreichen der unidirektionalen Wirkung des Wandlers. Ein weiteres Beispiel dieser Druckschrift betrifft die Verwendung solcher dreieckigen Reflektoren als Mittel zur Kopplung der Wellen zweier benachbarter Spuren der Wellenausbeutung in einer jeweiligen Oberflächenwellenanordnung. In diesem Zusammenhang sei auch noch die DE A-3811989 genannt, die Metallisierungsstrukturen angibt, deren schrägwinkelige Kanten solchen Schrägrichtungen der Wellen in einem Convolver dienen.

Aufgabe der vorliegenden Erfindung ist es, die bekannten Maßnahmen zur Unterdrückung störender Oberflächenwellenanteile in einer Oberflächenwellenanordnung zu ersetzen und/oder noch zusätzlich zu unterstützen. Insbesondere sollen diese erfahrungsgemäßen Maßnahmen wenig Substratfläche beanspruchen, da das Material der für Oberflächenwellenanordnungen verwendeten Substrate sehr kostspielig ist und/oder möglichst kleine Bauform erwünscht ist.

Mit der Erfindung wird für eine Oberflächenwellenanordnung mit auf einem Substratkörper für die Funktion der Anordnung vorgesehenen Oberflächenwellenstrukturen erreicht, daß das störende Auftreten solcher akustischer Wellenanteile, die auf Oberflächenwellen beruhen, die vorgegebenermaßen in einer Hauptausbreitungsrichtung in der Oberflächenwellenanordnung verlaufen, vermieden oder zumindest ganz erheblich gemindert sind. Mit der Erfindung werden also aus den eigentlichen, der Funktion der Oberflächenwellenanordnung als Filter, als Resonator oder dergleichen dienenden Oberflächenstrukturen (Wandler, Resonatoren, Reflektoren und dergleichen) dienenden Wellen zum Rand des Substratkörpers laufende und gelangende Wellenanteile, (die zum Beispiel bekanntermaßen in einem Sumpf beseitigt werden,) so beeinflußt, daß sie so weitgehend wie möglich nicht wieder in die die eigentliche Oberflächenwellenanordnung bildenden Strukturen zurückgelangen. Anders als dies mit einer Konversionsstruktur nach der WO 89/02675 erreicht wird, wird bei der vorliegenden Erfindung mit Hilfe einer noch näher zu erläuternden, erfindungsgemäß vorgesehenen Oberflächenstruktur dafür gesorgt, daß solche (zum Rand des Substrats gelangende) zu beseitigenden Oberflächenwellenanteile in der Weise und insoweit wegreflektiert werden, daß sie nicht mehr störend wirken können. Insbesondere ist bei mehrspurigen Anordnungen dafür gesorgt, daß diese Reflexionen so gerichtet sind, daß Störungen in der eigenen Spur und Störungen in den benachbarten Spuren ausgeschlossen sind.

Erfindungsgemäß ist für eine oben definierte Oberflächenwellenanordnung vorgesehen, daß zur Lösung des oben ebenfalls schon angegebenen Problems diese Oberflächenwellenanordnung (zusätzlich zu den der eigentlichen Funktion dieser Anordnung dienenden funktionswesentlichen Strukturen) außerhalb des Bereichs solcher funktionswesentlicher Strukturen wenigstens eine Oberflächenstruktur hat, die wenigstens eine im Winkel zur Hauptausbreitungsrichtung der akustischen Wellen der funktionswesentlichen Strukturen verlaufende, vorzugsweise im wesentlichen gradlinige Grenze hat, die den Bereich dieser auf dem Substratkörper vorgesehenen Oberflächenstruktur bzw. die den von dieser Oberflächenstruktur bedeckten Bereich der Substratoberfläche von einem daran angrenzenden Bereich des Substratkörpers trennt, wobei diese Oberflächenwellen in dem Bereich der genannten Oberflächenstruktur eine Ausbreitungsgeschwindigkeit $v_1$ haben und die Ausbreitungsgeschwindigkeit dieser Wellen im genannten angrenzenden Bereich $v_2$ ist mit $v_2$ verschieden von $v_1$. Diese genannte Grenze verläuft erfindungsgemäß in einem Winkel 3 zur Hauptausbreitungsrichtung, wobei dieser Winkel $\beta$ kleiner oder gleich $0.8 \cdot \beta g$ ist und näherungsweise gilt:

$$\beta_g = v_2 : v_1 \text{ für } V_2 \text{ kleiner als } v_1 \text{ bzw.}$$

$$\beta_g = v_1 : v_2 \text{ für } v_1 \text{ kleiner als } v_2.$$

(wobei der letztere Fall der Regelfall für die Erfindung ist).

Die erfindungsgemäß vorgesehene Oberflächenstruktur ist so angeordnet, daß die durch die funktionswesentlichen Strukturen der Oberflächenwellenanordnung vorgegebenen Oberflächenwellen im Bereich der kleineren Ausbreitungsgeschwindigkeit auf die Grenze zum Bereich mit der größeren Geschwindigkeit auftreffen.

Anhand der beigefügten Figuren wird dieser Erfindungsgedanke und werden weitere Ausgestaltungen der Erfindung dem Fachmann näher erläutert.

Figur 1        zeigt ein Übersichtsbild eines Beispiels einer Oberflächenwellenanordnung mit erfindungsgemäßer Oberflächenstruktur,

Figur 2, 2a     zeigt Einzelheiten einer Ausführungsform einer erfindungsgemäßen Oberflächenstruktur in einer Teildarstellung der Figur 1,

Figur 3     zeigt eine der Figur 2 entsprechende Teildarstellung einer Oberflächenwellenanordnung mit zwei Spuren und mit zugehörigen zwei erfindungsgemäßen Oberflächenstrukturen und

Figur 4     zeigt eine Variante einer erfindungsgemäßen Oberflächenstruktur.

Figur 5     bezieht sich auf eine weitere vorteilhafte Bemessung.

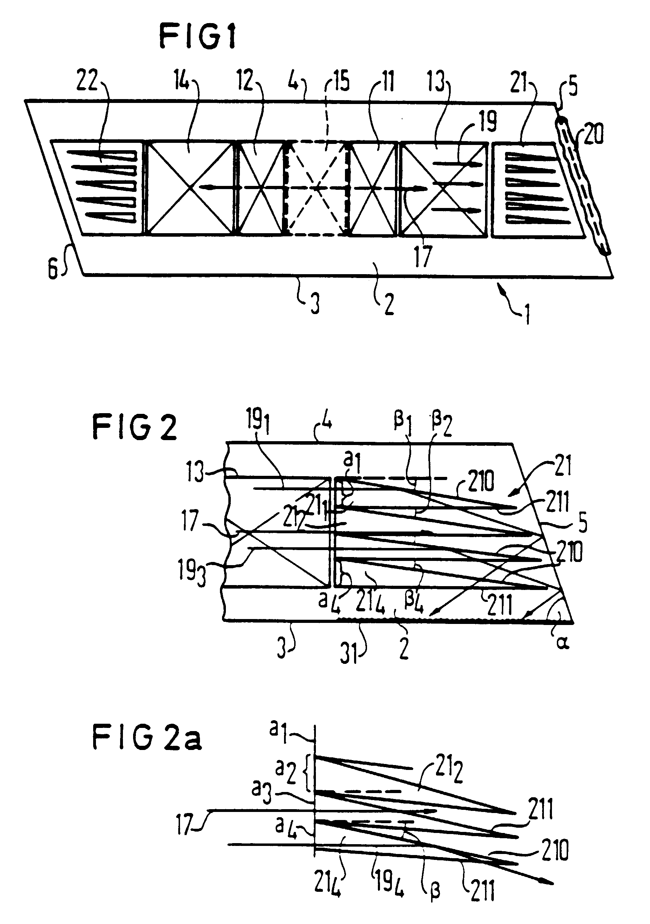

Die Oberflächenwellenanordnung 1 in Figur 1 ist eine an sich bekannte Anordnung von Oberflächenwellenstrukturen, wie sie als funktionswesentliche Bestandteile eines zum Beispiel Reflektorfilters bekannt sind. Das Substrat 2, auf dessen Oberfläche sich diese Oberflächenwellenstrukturen befinden, ist ein längliches Plättchen mit den Längskanten 3 und 4 und den beiden dazu im Winkel $\alpha$ schräg gerichteten Schmalseiten bzw. Endkanten 5 und 6. Mit 11 und 12 sind zwei Interdigitalwandler schematisch dargestellt, die als Eingangswandler und als Ausgangswandler dienen. Mit 13 und 14 sind Reflektorstrukturen bezeichnet, die aus Streifenstrukturen bestehen. Die interdigital angeordneten Finger der Wandler 11 und 12 und die Reflektorstreifen der Reflektoren 13 und 14 sind im Regelfall so angeordnet, daß sie senkrecht zu der sich daraus ergebenden Hauptwellenausbreitungsrichtung 17 ausgerichtet sind. Die Wellenfronten der in einer solchen Oberflächenwellenanordnung auftretenden akustischen Wellen stehen senkrecht zu dieser Richtung 17. Mit 19 ist in Figur 1 die Ausbreitung einer solchen ebenen akustischen Welle auf bzw. in der Oberfläche des Substrats 1 angedeutet.

Mit 15 ist eine zusätzliche Struktur bezeichnet, die alternativ vorgesehen sein kann, um den Zwischenraum zwischen dem Eingangswandler und dem Ausgangswandler 11, 12 auszufüllen. Einzelheiten über Sinn und Zweck einer solchen Struktur 15 sind zum Beispiel der EP-A-O 189 106 zu entnehmen.

Mit 21 und 22 sind erfindungsgemäß vorgesehene Oberflächenstrukturen des Substrats 1 bezeichnet, die dazu dienen, solche Wellen-Intensitätsanteile zu beeinflussen, die von den mit 19 bezeichneten Wellen ausgehend durch das in der Figur 1 rechtsseitige Ende der Reflektorstruktur 13 hindurch in die Oberflächenstruktur 21 hineingelangen. Solche Wellen-Intensitätsanteile würden bei Nichtvorhandensein einer wie erfindungsgemäßen Oberflächenstruktur 21 bis an die Kante 5 des Substrats 1 gelangen.

Nach dem Stand der Technik würden sie dann durch einen mit 20 angedeuteten Sumpf mehr oder weniger stark absorbiert werden, nämlich um zu verhindern, daß von dieser Kante 5 ein störender Anteil in den Bereich der für die Oberflächenwellenanordnung funktionswesentlichen Oberflächenwellenstrukturen 11 bis 14 zurückgelangen könnte. Ein wie mit 20 dargestellter Sumpf besteht nach dem Stand der Technik aus organischem Material, wie zum Beispiel einem aufgebrachten Kleber. Wie bekannt, sind solche Stoffe prinzipiell unerwünscht im Inneren des Gehäuses, in dem sich eine solche Oberflächenwellenanordnung hermetisch abgeschlossen befindet.

In der WO 89/02675 sind Konversionsstrukturen beschrieben, die anstelle eines solchen Sumpfes 20 verwendet werden können, und zwar in einem Oberflächenbereich des Substrats 1, in dem sich bei der vorliegenden Erfindung die erfindungsgemäßen Oberflächenstrukturen 21 und 22 befinden.

In der vorangehenden Beschreibung ist bereits die physikalische Wirkungsweise und sind die Bemessungsvorschriften für diese erfindungsgemäße Oberflächenstruktur erläutert worden.

Die Figur 2 zeigt einen Ausschnitt der Darstellung der Figur 1, aus dem zu ersehen ist, wie die Oberflächenstruktur 21 im einzelnen aufgebaut ist. Sie besteht zum Beispiel aus vier spitzwinkligen Oberflächenbelegungen der Oberfläche des Substrats 1. Vorzugsweise sind dies Metallbelegungen, insbesondere aus einem solchen Metall, wie es auch für die Finger bzw. Streifen der funktionswesentlichen Oberflächenwellenstrukturen 11 bis 14 verwendet wird. Diese spitzwinkligen Belegungen sind mit $21_1$ bis $21_4$ bezeichnet. Wie aus der Figur ersichtlich können die spitzen Enden der Belegungen der Oberflächenstruktur 21 bis nahe an die schräge Kante 5 des Substrats 1 heranreichen. Damit wird die zusätzlich zur Fläche der Strukturen 11 bis 15 zur Verfügung stehende Substratoberfläche optimal für die erfindungsgemäße Funktion der Oberflächenstruktur 21 ausgenutzt.

Entsprechendes gilt für die Oberflächenstruktur 22 des entgegengesetzten Endes des Substrats 1.

Mit $\beta_1$ bis $\beta_4$ sind die Winkelabweichungen der Kanten 210 der Belegungen $21_1$ bis $21_4$ gegenüber der Hauptwellenausbreitungsrichtung 17 bezeichnet. Wie mit den Beispielen $19_1$ und $19_3$ gezeigt, läuft die Oberflächenwelle 19 im Reflektor 13, wobei ein Intensitätsanteil dieser Welle 19 über das rechtsseitige Ende des Reflektors 13 ungebrochen in die Oberflächenstruktur 21 eintritt. Mit $a_1$ bis $a_4$ sind die Breitenabmessungen der Belegungen $21_1$ bis $21_4$ an der Grenze zum Reflektor 13 bezeichnet. Zu den Kanten 211 der Oberflächenstruktur 21 verläuft dieser Wellenanteil $19_1$ ... parallel.

Die Intensitätsanteile, die auf die im Winkel $\beta$ spitzwinklig ausgerichteten Kanten 210 der Belegungen $21_1$ bis $21_4$ auftreffen werden an diesen Kanten, die wie oben bezeichnete Grenzen zwischen zwei verschiedenen Bereichen sind totalreflektiert. Dies beruht darauf, daß die Winkel $\beta_1$ bis $\beta_4$ kleiner als der Grenzwinkel $\beta_g$ für die Totalreflexion bemessen sind, bei der eine Welle in einem für diese Welle dichteren Medium auf die Grenze zu einem für diese Welle dünneren Medium auftrifft. In dem hier zugrundegelegten Regelfall hat die akustische Welle in der Oberfläche bzw. im oberflächennahen Bereich des Substrats unterhalb der Belegungen $21_1$ bis $21_4$ eine geringere Fortpflanzungsgeschwindigkeit. In Bereichen unbelegter Oberfläche des Substrats ist die Wellenfortpflanzungsgeschwindigkeit höher. Bei der oben in Seite 4 angegebenen Bemessungsregel ist auch der umgekehrte Fall berücksichtigt.

Aus der Figur 2 ist zu ersehen, wie die Wellenanteile $19_1$ $19_3$ an den Kanten bzw. Grenzen 210 totalreflektiert werden. Desweiteren ist die Reflexion der totalreflektierten Anteile an der Kante 5 dargestellt. Die Brechung sowie Reflexion der totalreflektierten Anteile an den Kanten 211 der Oberflächenstruktur 21 ist in der Figur außer Acht gelassen. In der Praxis wird dies berücksichtigt, jedoch ohne daß dies für die Funktion der erfindungsgemäßen Oberflächenstruktur wesentlich ist.

Zur Absorption von auf die Längsseite 3 des Substrats 2 auftreffende Wellenanteile kann diese bzw. können andere Seitenfläche(-n) des Substrats wie mit 31 angedeutet aufgerauht sein, womit weitere Streuung auftreffender Anteile erzielt wird.

Wegen der der Schrägrichtung der Kante 5 angepaßten schrägen Ausrichtung der spitzen Enden der Belegungen $21_1$ bis $21_4$ können bei zum Beispiel äquidestanten Breiten $a_1$ bis $a_4$ die Winkel $\beta_1$ bis $\beta_4$ geringfügig unterschiedlich groß sein, müssen aber stets kleiner als der Grenzwinkel $\beta_g$ der Totalreflexion sein. Es empfiehlt sich den Winkel $\beta$ stets kleiner als wenigstens angenähert $0{,}7 \times \beta_g$ zu bemessen. Es kann aber auch stets gleichbleibender Winkel $\beta$ vorgesehen sein, womit dann die Breiten $a_1$ bis $a_4$ etwas voneinander unterschiedlich groß sind. Es ist nicht ausgeschlossen, daß die Kanten 210 auch von der dargestellten Gradlinigkeit etwas abweichen können.

Die Darstellung der Figur 2a zeigt eine Ausführung, bei der die Kante 211 eine zur Hauptwellenausbreitungsrichtung 17 nicht parallele Ausrichtung hat, sondern in einem "negativen" Winkel ausgerichtet ist, so daß diese Kante 211 auch in Figur 2a nicht von der akustischen Welle 19 getroffen wird.

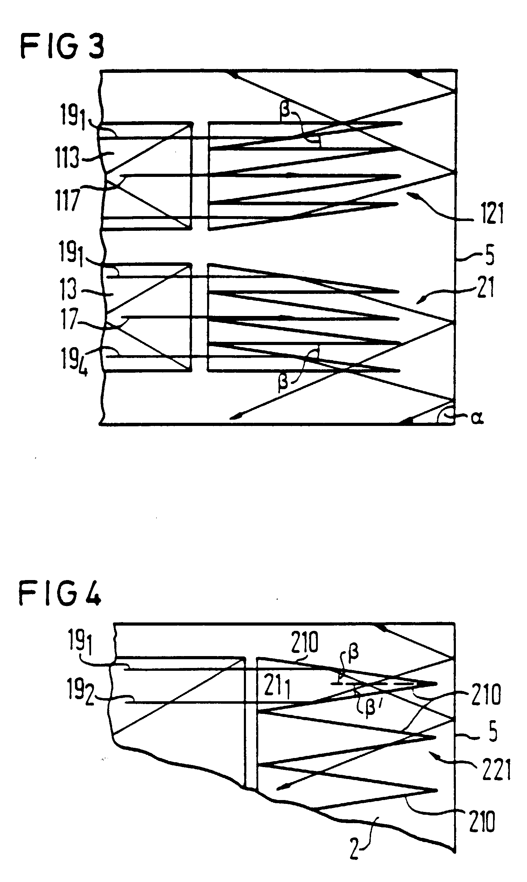

Die Figur 3 zeigt eine Zweispuranordnung mit den Hauptwellenausbreitungsrichtungen 17 und 117 der beiden Spuren der Oberflächenwellenanordnung dieser Figur. Der in Figur 3 dargestellte Ausschnitt entspricht dem Ausschnitt der Figur 2 aus der Figur 1. Die Bezugszeichen der Oberflächenstruktur 21 der Figur 3 haben identische Bedeutung mit denen der Figuren 1 und 2. Die Oberflächenstruktur 121 der Figur 3 entspricht prinzipiell der Oberflächenstruktur 21, jedoch ist der Winkel $\beta$ der Struktur 121 entgegengesetzt dem Winkel $\beta$ der Struktur 21 gerichtet.

Wie aus der Figur 3 ersichtlich, werden die in den erfindungsgemäß vorgesehenen Oberflächenstrukturen 21 und 121 total reflektierten Wellenanteile von den parallelen Hauptwellenausbreitungsrichtungen 17 und 117 der beiden Spuren gegensinnig wegreflektiert, so daß ein Übersprechen zwischen den beiden Spuren weitgehendst ausgeschlossen ist.

Die Figur 4 zeigt eine Ausführungsform, wie sie für eine Oberflächenwellenanordnung mit nur einer Spur alternativ verwendet werden kann. Die erfindungsgemäße Oberflächenstruktur ist mit 221 bezeichnet. Die für die Funktion entscheidenden Kanten bzw. Grenzen vom Bereich niedriger Wellengeschwindigkeit zum Bereich höherer Wellengeschwindigkeit sind wieder mit 210 bezeichnet. Prinzipiell sind die dreieckigen Belegungen $21_1$ der Oberflächenstruktur 221 solche Belegungen, wie sie in Figur 2 mit $21_1$ und so weiter bezeichnet sind, wobei zwei solche Strukturen $21_1$ mit den Kanten 211 Rücken - an Rücken - aneinandergefügt sind. Die ablenkende Wirkung der Kanten 210 der Oberflächenstruktur 221 für die Oberflächenwelle 19 zeigen die in die Figur 4 eingetragenen Linienzüge $19_1$ und $19_2$. Die Winkel $\beta$ und $\beta'$ brauchen nicht gleich groß zu sein, sie müssen nur der obigen Vorschrift entsprechen.

Die dargestellten Ausführungsformen der Erfindung zeigen Oberflächenstrukturen 21, 121 und 221, die aus jeweils einer Mehrzahl von solchen spitzwinkligen Dreiecken als Oberflächenbelegungen des Substrats bestehen. Je größer die Anzahl der einzelnen spitzwinkligen Dreiecksbelegungen für eine vorgegebene Breite der Wellenfront 19 (Breite gemessen quer zur Hauptwellenausbreitungsrichtung 17) gewählt ist, um so kürzer kann die ganze Oberflächenstruktur 21, 121, 221 in Richtung der Hauptwellenausbreitungsrichtung 17 bemessen sein. Dies ist vorteilhaft hinsichtlich verringerter Länge des Substratplättchens 2. Andererseits darf aber die Breitenabmessung $a_1$, $a_2$ ... nicht beliebig klein gemacht werden, um nicht Beugungseffekte und dergleichen in Kauf nehmen zu müssen. Die Abmessung a sollte nicht kleiner als eine Wellenlänge der akustischen Welle 19 der Oberflächenwellenanordnung betragen.

Nachfolgend werden die Berechnungsunterlagen für die Bemessung gegeben:

Der erforderliche Winkel der Totalreflexion und damit der maximale Winkel $\beta_g$ zwischen der Kante bzw. Grenze 210 und der Hauptwellenausbreitungsrichtung 17 ergibt sich aus den Geschwindigkeiten der akustischen Welle in den jeweiligen Bereichen:

$$\cos(\beta_g) = v_s / v_f$$

Die Geschwindigkeit ($v_f$) unter der freien und die Geschwindigkeit ($v_s$) unter der mit Metall (21) belegten Oberfläche des Substrats stehen näherungsweise mit dem Kopplungsfaktor im folgenden Zusammenhang:

$$v_s = v_f * (1 - k^2/2)$$

Somit vereinfacht sich die Gleichung für den maximalen Winkel zu:

$$\cos(\beta_g) = 1 - k^2/2$$

Die praktische Bemessung des Winkels β der Oberflächenstruktur muß folgende Bedingung erfüllen:

β kleiner als $\beta_g$ und mit einem Sicherheitsfaktor 0,8 somit kleiner als 0,8 $\beta_g$.

Da die Welle beim Austritt aus der Struktur nochmals an der Kante gebrochen wird, ergibt sich eine unwesentliche Verringerung für den resultierenden Ablenkwinkel.

Für gängige Materialien ergeben sich näherungsweise folgende Winkel:

| Material | $k^2$ | $\beta_g$(°) |
|---|---|---|
| LiTaO$_3$-X,112rotY | 0.0075 | 5 |
| LiTaO$_3$-36rotY,X | 0.07 | 15,2 |
| LiNbO3-128rotY,X | 0.055 | 13,5 |
| LiNbO3-YZ | 0.045 | 12,2 |

Wenn die Welle mit einem dementsprechenden Winkel β auf die Kante 210 trifft, so wird sie auf jeden Fall von der Spur wegreflektiert.

Der entscheidende Vorteil dieser erfindungsgemäßen Oberflächenstruktur ist, daß sie keinen weiteren Herstellungsprozeß benötigt. Die Struktur wird im gleichen Prozeß wie das Filterlayout hergestellt.

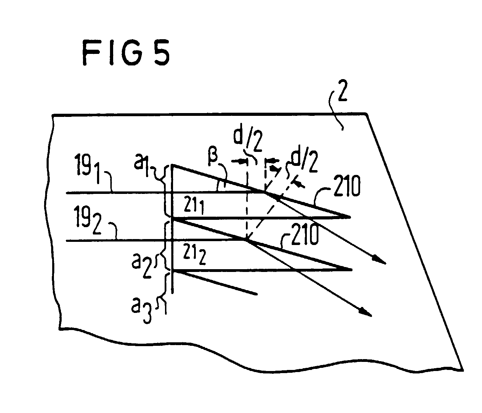

Von besonderem Vorteil ist es, den Winkel β so zu wählen, daß sich in die Struktur eingetrennte Wellenanteile $19_1$ und $19_2$ benachbarter Bereiche der Breiten $a_1$ und $a_2$ ($a_2$ und $a_c$ usw.) nach Reflexion an den Kanten 210 durch Interferenz gegenseitig auslöschen. Dies zeigt die Figur 5, in der diese Bemessung des Winkels β so gewählt wird, daß die Länge d, das heißt der Wegunterschied in benachbarten Bereichen 21 totalreflektierter Wellenanteile $19_1$ und $19_2$ nach deren Reflexion gleich der halben (mittleren) Wellenlänge der Welle unterhalb der jeweiligen Belegung $21_1$, $21_2$ ist. Unter dieser Bedingung löschen sich die beiden in Figur 5 gezeigten totalreflektierten Strahlen gegenseitig aus.

## Patentansprüche

1. Für eine Oberflächenwellenanordnung (1) mit einem Substrat (2) vorgesehene Oberflächenstruktur (21, 121, 221) zur Vermeidung störender akustischer Wellenanteile, die auf akustischen Oberflächenwellen (19) beruhen, die vorgegebenermaßen in einer Hauptwellenausbreitungsrichtung (17) in der Oberflächenwellenanordnung (1) verlaufen,

- wobei diese Oberflächenstruktur (21, 121, 221) wenigstens eine im Winkel β zur Hauptwellenausbreitungsrichtung verlaufende, im wesentlichen gradlinige Grenze (210) hat, die einen Bereich ($21_1$, $21_2$ ... ) der Oberflächenstruktur von einem daran angrenzenden Bereich der Oberfläche des Substrats (2) trennt, wobei die Oberflächenwelle (19) in diesem Bereich ($21_1$, $21_2$ ...) der Oberflächenstruktur eine Ausbreitungsgeschwindigkeit ($v_1$) hat und die Ausbreitungsgeschwindigkeit ($v_2$) der Oberflächenwelle in dem angrenzenden Bereich verschieden von $v_1$ ist,

- wobei der Winkel β dieser Grenze (210) kleiner oder gleich etwa 0,8 . $\beta_g$ beträgt, wofür gilt:

$$\cos\beta_g = v_2/v_1 \text{ für } v_2 \text{ kleiner als } v_1 \text{ bzw.}$$

$$\cos\beta_g = v_1/v_2 \text{ für } v_1 \text{ kleiner als } v_2 \text{ und}$$

- wobei die Oberflächenstruktur so angeordnet ist, daß die vorgegebenen Oberflächenwellen (19) im Bereich der kleineren Geschwindigkeit der Oberflächenwelle auf diese Grenze (210) auftrifft und an dieser Grenze (210) total reflektiert wird.

2. Oberflächenwellenanordnung mit Oberflächenstruktur nach Anspruch 1
bei der diese Oberflächenstruktur (21, 121, 221) aus einer Mehrzahl dem Winkel β der Grenze (210) entsprechenden spitzwinkligen Bereichen ($21_1$, $21_2$ ...) besteht.

3. Oberflächenwellenanordnung mit Oberflächenstruktur nach Anspruch 2
mit Bereichen ($21_1$, $21_2$ ...) der Oberflächenstruktur (21, 121, 221), die gleich große Breite quer zur Hauptwellenausbreitungsrichtung (17) am Eintrittsende der Oberflächenwelle in diese Oberflächenstruktur haben.

4. Oberflächenwellenanordnung mit Oberflächenstruktur nach Anspruch 2 oder 3
mit abgeschrägter Kontur der Oberflächenstruktur (21) an dem dem Eintrittsende der Oberflächenwelle in diese Oberflächenstruktur befindlichen Ende derselben.

5. Oberflächenwellenanordnung mit Oberflächenstruktur nach einem der Ansprüche 2 bis 4
mit voneinander unterschiedlich großen Winkeln β der einzelnen Bereiche ($21_1$, $21_2$ ...) der Oberflächenstruktur bei unterschiedlicher Länge der Bereiche ($21_1$, $21_2$ ...), gemessen in Richtung der Hauptwellenausbreitungsrichtung (17).

6. Oberflächenwellenanordnung mit Oberflächenstruktur nach einem der Ansprüche 2 bis 5 mit voneinander unterschiedlich großen Abmessungen der Breite ($a_1$, $a_2$ ...) der Belegungen ($21_1$, $21_2$ ...) der Oberflächenstruktur (21, 121, 221) an deren der Mitte der Oberflächenwellenanordnung zugewandtem Ende.

7. Oberflächenwellenanordnung mit Oberflächenstruktur nach einem der Ansprüche 1 bis 6 mit wenigstens einer weiteren Grenze (210) des Bereichs ($21_1$, $21_2$ ...), die im wesentlichen parallel der Hauptwellenausbreitungsrichtung (17) ausgerichtet ist.

8. Oberflächenwellenanordnung mit Oberflächenstruktur nach einem der Ansprüche 1 bis 7 mit wenigstens einem Bereich der Oberflächenstruktur (221), der von zwei Grenzen (210) begrenzt ist, die jeweils im Winkel $\beta$ zur Hauptwellenausbreitungsrichtung (17) verlaufen.

9. Oberflächenwellenanordnung mit zwei Spuren mit Oberflächenstrukturen (21, 121) nach einem der Ansprüche 1 bis 8, mit einer solchen Ausrichtung der im Winkel $\beta$ zur Hauptwellenausbreitungsrichtung (17) verlaufenden Grenzen (210), die bewirken, daß die in die jeweilige Oberflächenstruktur (21, 121) gelangenden Anteile der Oberflächenwelle (19) in bezogen auf die gesamte Oberflächenwellenanordnung zueinander entgegengesetzten Richtungen, bezogen auf die Hauptwellenausbreitungsrichtung (17, 117) reflektiert werden.

10. Oberflächenwellenanordnung nach einem der Ansprüche 1 bis 9, bei der der Winkel $\beta$ der Ausrichtung der totalreflektierenden Kanten (210) so gewählt ist, daß in benachbarten Bereichen (21) totalreflektierte Wellenanteile sich nach erfolgter Reflexion gegenseitig durch Interferenz auslöschen.

**Claims**

1. Surface structure (21, 121, 221), which is intended for a surface wave arrangement (1) having a substrate (2), in order to prevent interfering acoustic wave components which are caused by surface acoustic waves (19) which run in a predetermined manner in a main wave propagation direction (17) in the surface wave arrangement (1),

   - this surface structure (21, 121, 221) having at least one essentially straight boundary (210) which runs at an angle $\beta$ to the main wave propogation direction and separates an area ($21_1$, $21_2$ ...) of the surface structure from an area, which is adjacent thereto, of the surface of the substrate (2), the surface wave (19) having a propogation speed ($v_1$) is this area ($21_1$, $21_2$ ...) of the surface structure, and the propogation speed ($v_2$) of the surface wave in the adjacent area being different from $v_1$,

   - the angle $\beta$ of this boundary (210) being less than or equal to about 0.8 , $\beta_g$, where:

   $$\cos\beta_g = v_2/v_1 \text{ if } v_2 \text{ is less than } v_1\text{, and}$$

   $$\cos\beta_g = v_1/v_2 \text{ if } v_1 \text{ is less than } v_2\text{, and}$$

   - the surface structure being arranged such that the predetermined surface waves (19) arrive at this boundary (210) in the area where the surface wave has a lower speed, and being totally reflected at this boundary (210).

2. Surface wave arrangement having a surface structure according to Claim 1, in the case of which this surface structure (21, 121, 221) is composed of a plurality of acute-angled areas ($21_1$, $21_2$ ...) which correspond to the angle $\beta$ of the boundary (210).

3. Surface wave arrangement having a surface structure according to Claim 2, having areas ($21_1$, $21_2$) of the surface structure (21, 121, 221) which have the same width transversely with respect to the main wave propogation direction (17) at the inlet end of the surface wave into the surface structure.

4. Surface wave arrangement having a surface structure according to Claim 2 or 3, having an inclined contour of the surface structure (21) at that end of the same which is located at the inlet end of the surface wave into this surface structure.

5. Surface wave arrangement having a surface structure according to one of Claims 2 to 4, having angles $\beta$, which are of different size from one another, of the individual areas ($21_1$, $21_2$ ...) of the surface structure for a different length of the areas ($21_1$, $21_2$...), measured in the direction of the main wave propagation direction (17).

6. Surface wave arrangement having a surface structure according to one of Claims 2 to 5 having dimensions of the width ($a_1$, $a_2$ ...) of the areas ($21_1$, $21_2$ ...) of the surface structure (21, 121, 221) which are of different size from one another at their end facing the centre of the surface wave arrangement.

7. Surface wave arrangement having a surface structure according to one of Claims 1 to 6, having at least one further boundary (210) of the area ($21_1$, $21_2$ ...), which boundary (210) is aligned essentially parallel to the main wave propogation direction (17).

8. Surface wave arrangement having a surface structure according to one of Claims 1 to 7, having at least one area of the surface structure (221) which is bounded by two boundaries (210) which each run at the angle β to the main wave propogation direction (17).

9. Surface wave arrangement having two tracks with surface structures (21, 121) according to one of Claims 1 to 8, in which the boundaries (210) which run at the angle β to the main wave propogation direction (17) are aligned such that those components of the surface wave (19) which enter the respective surface structure (21, 121) are reflected, with respect to the main wave propogation direction (17, 117), in opposite directions to one another with respect to the overall surface wave arrangement.

10. Surface wave arrangement according to one of Claims 1 to 9, in which the angle β of the alignment of the totally reflecting edges (210) is selected such that totally reflected wave components in adjacent areas (21) cancel one another out after reflection has taken place, as a result of interference.

**Revendications**

1. Structure de surface (21, 121, 221), prévue pour un dispositif à ondes de surface (1) comportant un substrat (2), pour empêcher des composantes parasites d'ondes acoustiques qui viennent d'ondes de surface (19) acoustiques qui se propagent de manière prédéterminée selon une direction principale (17) de propagation des ondes dans le dispositif à ondes de surface (1),

- cette structure de surface (21, 121, 221) ayant au moins une limite (210), globalement rectiligne et formant un angle β avec la direction principale de propagation des ondes, qui sépare une zone ($21_1$, $21_2$ ...) de la structure de surface d'une zone adjacente de la surface du substrat (2), l'onde de surface (19) dans cette zone ($21_1$, $21_2$ ...) de la structure de surface ayant une vitesse de propagation ($v_1$) et la vitesse de propagation ($v_2$) de l'onde de surface dans la zone adjacente étant différente de $v_1$,
- l'angle β de cette limite (210) étant à peu près inférieur ou égal à 0,8 . $β_g$, avec :

$$\cos β_g = v_2/v_1 \text{ pour } v_2 \text{ inférieur à } v_1 \text{ ou}$$

$$\cos β_g = v_1/v_2 \text{ pour } v_1 \text{ inférieur à } v_2, \text{ et}$$

- la structure de surface étant agencée de telle sorte que les ondes de surface (19) prescrites arrivent dans la zone de la plus petite vitesse de l'onde de surface à cette limite (210) et qu'elles sont totalement réfléchies par cette limite (210).

2. Dispositif à ondes de surface comportant une structure de surface selon la revendication 1, selon lequel cette structure de surface (21, 121, 221) est constituée d'une multiplicité de zones à angle aigu ($21_1$, $21_2$ ...) qui correspondent à l'angle β de la limite (210).

3. Dispositif à ondes de surface comportant une structure de surface selon la revendication 2, comportant des zones ($21_1$, $21_2$ ...) de la structure de surface (21, 121, 221) qui ont la même largeur transversalement à la direction principale (17) de propagation des ondes à l'extrémité d'entrée de l'onde de surface dans cette structure de surface.

4. Dispositif à ondes de surface comportant une structure de surface selon la revendication 2 ou 3, ayant un contour oblique de la structure de surface (21) à l'extrémité, de cette structure de surface, qui se trouve à l'extrémité d'entrée de l'onde de surface dans cette structure de surface.

5. Dispositif à ondes de surface comportant une structure de surface selon l'une des revendications 2 à 4, ayant des valeurs pour les angles β des différentes zones ($21_1$, $21_2$ ...) de la structure de surface pour une longueur différente des zones ($21_1$, $21_2$ ...), mesurées selon la direction principale (17) de propagation des ondes.

6. Dispositif à ondes de surface comportant une structure de surface selon l'une des revendications 2 à 5, ayant des largeurs différentes ($a_1$, $a_2$ ...) des revêtements ($21_1$, $21_2$ ...) de la structure de surface (21, 121, 221) à l'extrémité de ces revêtements qui sont tournées vers le centre du dispositif à ondes de surface.

7. Dispositif à ondes de surface comportant une structure de surface selon l'une des revendications 1 à 6, ayant au moins une autre limite (210) de la zone ($21_1$, $21_2$ ...), laquelle limite est orientée sensiblement parallèlement à la direction principale (17) de propagation des ondes.

8. Dispositif à ondes de surface comportant une structure de surface selon l'une des revendications 1 à 7, ayant au moins une zone de la structure de surface (221) qui est limitée par deux limites (210) qui forment chacune un angle β avec la direction principale (17) de propagation des ondes.

9. Dispositif à ondes de surface comportant deux pistes ayant des structures de surface (21, 121) selon l'une des revendications 1 à 8, ayant une telle orientation des limites (210) formant un angle β avec la direction principale (17) de propagation des ondes que les composantes de l'onde de surface (19) qui arrivent dans la structure de surface (21, 121) respective sont réfléchies, par rapport à la direction principale (17, 117) de propagation des ondes, selon des directions allant à l'opposé l'une de l'autre par rapport à l'ensemble du dispositif à ondes de surface.

10. Dispositif à ondes de surface selon l'une des revendications 1 à 9, selon lequel l'angle β de l'orientation des arêtes (210) totalement réfléchissantes est choisi tel que des composantes d'ondes totalement réfléchies dans des zones (21) voisines s'annulent mutuellement par interférence après leur réflexion.

# FIG 1

# FIG 2

# FIG 2a

## FIG 3

## FIG 4

FIG 5